(19) Europäisches Patentamt
European Patent Office
Office européen des brevets

(11) Publication number: **0 456 066 A2**

# (12) EUROPEAN PATENT APPLICATION

(21) Application number: **91106888.0**

(22) Date of filing: **27.04.91**

(51) Int. Cl.[5]: **H01L 23/498**, H01L 23/31, H01L 21/60

(30) Priority: **08.05.90 JP 118427/90**
**16.05.90 JP 126140/90**
**16.05.90 JP 51113/90 U**
**12.04.91 JP 80068/91**

(43) Date of publication of application:
**13.11.91 Bulletin 91/46**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Kasahara, Yoshihiko, c/o Seiko Epson Corp.**
**3-5, Owa 3-chome**
**Suwa-shi, Nagano-ken(JP)**
Inventor: **Ito, Tatsuro, c/o Seiko Epson Corporation**
**3-5, Owa 3-chome**
**Suwa-shi, Nagano-ken(JP)**

(74) Representative: **Blumbach Weser Bergen Kramer Zwirner Hoffmann Patentanwälte**
**Radeckestrasse 43**
**W-8000 München 60(DE)**

## (54) Semiconductor chip mounted inside a device hole of a film carrier.

(57) A semiconductor device comprises a semiconductor chip (2) inside a device hole (3) of a film carrier (1) having a conductive pattern (4) formed thereon, wherein inner leads (5) projecting from leads of the conductive pattern (4) into the device hole (3) are respectively connected to terminals provided on the semiconductor chip (2), and the semiconductor chip (2) or the semiconductor chip and portions of the conductive pattern (4) are sealed with a sealing resin (8). The width of a gap formed between the edge of the device hole (3) and the outer periphery of the semiconductor chip (2) is 0.4 mm to 0.8 mm. Bent portions may be provided substantially at a midway position on said inner leads. Further, cut-out portions may be provided beside each lead of the conductive pattern (4) in the edge of the film carrier (1) surrounding the device hole (3). These features make the inner leads more pliant and/or avoid concentration of stress imported on the inner leads, so that lead brakes and poor bonding connections are substantially prevented.

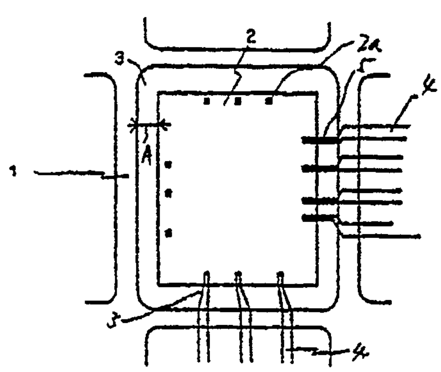


FIG. 1

EP 0 456 066 A2

The present invention relates to a semiconductor device and, more particularly, to a semiconductor device comprising a semiconductor chip disposed within a hole of a film carrier and connected to leads that form a conductive pattern on the film carrier and extend into the hole.

For a better appreciation of the background of the invention, reference is first made to Figs. 6 to 11 showing conventional semiconductor devices of such kind. As shown in Figs. 6 and 7, a film carrier 1 made of an insulation film comprising a polymer material such as polyester or polyimide and having a thickness of about 50 to 125 µm, has formed therein a device hole 3. Disposed within the device hole 3 is a semiconductor chip 2 forming an integrated circuit element. The area of the device hole 3 is larger than the surface area of the semiconductor chip 2 such that a gap B (Fig. 7) is formed between the edge of the hole and the outer periphery of the semiconductor chip 2. The width of this gap is 0.15 mm to 0.40 mm. Plural terminals 2a are provided on the active surface of semiconductor chip 2. Leads forming a conductive pattern 4 are provided on the carrier film 1. The leads are made of a copper foil, each being 50 to 300 µm wide and 15 to 40 µm thick and connected by an adhesive 6 to the film carrier 1. The leads extend into the device hole 3 forming inner leads 5 whose tips are connected by pressure melt adhesion to the terminals 2a of the semiconductor chip 2. The leads of the conductive pattern 4 on the film carrier 1 are arranged according to the configuration of the terminals 2a and are formed to extend straight ahead into the device hole 3 to be substantially perpendicular to the corresponding edge of the semiconductor chip 2. Sprocket holes 7 are provided in the film carrier 1 for transporting the film carrier.

After the tips of the inner leads 5 have been connected to the terminals 2a of the semiconductor chip 2, the semiconductor chip, the inner leads 5 and a portion of the conductive pattern 4 are sealed with a sealing resin 8 by such as squeegee printing or bonding as shown in Fig. 8, after which the film carrier 1 and the conductive pattern 4 are cut to complete the semiconductor device. Fig. 8 shows an example where the active surface of the semiconductor chip 2 faces upward, i.e. the lower side of the inner leads 5. In the example of Fig. 9 the active surface of the semiconductor chip 2 faces downward, i.e. the upper side of the inner leads 5. In the case of Fig. 10 only the semiconductor chip 2 is covered with a sealing resin 8.

With the conventional semiconductor device described above, when the semiconductor chip 2 is connected to the inner leads 5 with its active surface facing upward (Fig. 7), the inner leads 5 are retained (bent?) by the film carrier 1 as shown in Fig. 11(a) with the semiconductor chip 2 in a hanging state. Since the inner leads 5 made of copper with a thickness on the order of 40 µm, for example, are softer than the film carrier 1 made of a polyimide resin with a thickness on the order of 100 µm, a force is concentrated on the base end portion of the inner leads 5 as shown by the arrow in Fig. 11(a). This leads to problems of expansion and contraction under temperature changes and tension and torsion from handling and by that, to the occurrence of cracks and breaks in these base end portions as shown in Fig. 11(b).

Also, when the semiconductor chip 2 and portions of the conductive pattern 4 are sealed with a sealing resin 8 as shown in Figs. 8 and 9, stresses such as a heat stress and a stress during hardening of the sealing resin 8 act on the inner leads 5. These stresses also concentrate on the base end portions of the inner leads 5 causing lead breaks to occur at these end portions. Furthermore, the connections of the inner leads 5 to the semiconductor 2 may become loose because of a torsion of the inner leads 5 creating the problem of poor quality bonding connections.

If, on the other hand, only the active surface of the semiconductor chip 2 is sealed as shown in Fig. 10, external stresses from handling and transport after bonding and sealing are exerted on the inner leads 5, these external stresses concentrating on the base end portions of the inner leads 5 and inducing the same problems as mentioned above.

The invention is intended to solve these problems and its object is to provide a semiconductor device having good quality bonding connections and high reliability.

This object is achieved with a semiconductor device as claimed.

According to one aspect of the present invention, a semiconductor chip is disposed within a device hole of the film carrier. The device hole is larger than the semiconductor chip so that a gap is formed between the outer periphery of the semiconductor chip and the edge of the film carrier surrounding the device hole. Inner leads extending from corresponding leads of a conductive pattern formed on the film carrier, into the device hole are connected to plural terminals provided on the semiconductor chip. The semiconductor chip or the semiconductor chip and portions of the conductive pattern are sealed with a sealing resin. According to the invention, the width of the gap is 0.4 mm to 0.8 mm.

The inner leads may be provided with bent portions at substantially midway positions.

Cut-out portion may further be provided beside each lead of the conductive pattern at the edge of the device hole of the film carrier. These cut-out portions are preferred to have a long and narrow rectangular shape.

Either the length of the inner leads projecting into the device hole is elongated to make them pliant or bent portions are provided nearly midway on the inner leads and the length of the inner leads projecting into the device hole is lengthened to make them pliant and easily bent at the bent portions, so that the inner leads will bend under stress occurring during the setting of the sealing resin or stress occurring at transport and handling after the inner leads have been connected to the semiconductor chip. Bent portions of the inner leads will bend to absorb and relax such stress. Consequently, the occurrence of poor bonding connections and lead breaks in the inner leads that occurred with the prior art because of such stress are substantially less likely to occur.

Where cut-out portions are provided at the sides of each lead of the conductive pattern at the edge of the device hole, tongue-shaped portions of the film carrier with the respective lead thereon are formed between cut-outs. These tongues are easily bendable preventing the forces acting on the inner leads to concentrate at one portion of an inner lead. Instead, the inner lead bends together with the tongue-shaped portion of the film carrier in response to external forces without local concentration of such forces at the inner leads. External forces may be due to expansion and contraction under temperature changes and tension and torsion occurring after the inner leads have been connected to the semiconductor chip. Consequently, the occurrence of poor bonding connections and lead breaks in the inner leads that have occurred in the prior art because of these external forces are substantially decreased.

Specific embodiments of the present invention will be explained in detail below with reference to the drawings, in which:

| | |
|---|---|
| Fig. 1 | is a plan view showing an example of the present invention before sealing, |
| Fig. 2 | is a sectional view of the arrangement shown in Fig. 1, |
| Fig. 3 | is a plan view showing another example of the present invention before sealing, |
| Fig. 4 | is a partial plan view showing still another example of the present invention before sealing, |
| Fig. 5 | is a partial sectional view of the arrangement shown in Fig. 4, |
| Fig. 6 | is a plan view of a prior art semiconductor device before sealing, |
| Fig. 7 | is a sectional view of the arrangement shown in Fig. 6. |
| Fig. 8 | is a sectional view showing the prior art semiconductor device after sealing, |
| Fig. 9 | is a sectional view corresponding to Fig. 8 with the semiconductor chip mounted in a reversed state, |
| Fig. 10 | is a sectional view showing the semiconductor device of Figs. 6 and 7 with a different sealing, and |
| Figs. 11(a) and 11(b) | are explanatory diagrams for explaining problems occurring with the prior art semiconductor device. |

Fig. 1 is a plan view showing a semiconductor device according to one embodiment of the present invention before sealing. Fig. 2 is a sectional view of this semiconductor device. Throughout the Figures the same reference signs are used to designate the same elements, and elements that have been explained already with reference to Figs. 6 to 10 will not be explained again.

In this embodiment of the invention, the width A (Fig. 2) of the gap formed between the semiconductor chip 2 and the surrounding edge of the film carrier 1 forming the device hole 3 has a value of 0.4 mm to 0.8 mm, i.e. is larger than in the prior art semiconductor device. The length of the inner leads 5 projecting into the device hole 3 is increased correspondingly. After the inner leads 5 and semiconductor chip 2 have been connected, the semiconductor chip 2 and portions of the conductive pattern 4 are sealed with the sealing resin 8. Thereafter, the film carrier 1 and the conductive pattern 4 are cut to form the semiconductor device. The sealing and cutting steps are the same as in the prior art.

Table 1 shows the result of a comparative investigation of the lead break yields of inner leads of a semiconductor device according to the prior art and a semiconductor device according to an embodiment of the present invention. In Table 1 the width of the gap surrounding the semiconductor chip 2 is divided into four regions, namely 0.15 - 0.40 corresponding to the prior art, 0.40 to 0.80 and 0.60 to 0.80, corresponding to the invention and 0.80 and more. For each range the lead break yield and the total yield including the bonding yields between the inner leads and the semiconductor chip are shown.

Table 1

| Gap (mm) | 0.15 ~ 0.40 | 0.40 ~ 0.80 | 0.60 ~ 0.80 | 0.80 and more |
|---|---|---|---|---|
| Lead break yield | lead breaks occurred | no lead breaks | no lead breaks | no lead breaks |
| Total yield | lead breaks and bonding problems occurred | no lead breaks and no bonding problems occurred | no lead breaks and no bonding problems occurred | lead breaks and bonding problems occurred |

As will be clear from Table 1, the two ranges according to the invention, where the gap width A is 0.40 mm to 0.60 mm and 0.60 to 0.80 mm, respectively, have lead break yields and total yields that are both better than those of the prior art. This is to a certain extent due to the fact that the gap width A is made wider than in the prior art and also because of the increased length of the inner leads 5 making them more pliant. Stresses occurring due to reasons mentioned before are better absorbed and relaxed in a semiconductor device according to the invention.

Because the inner leads 5 bend and absorb and relax external stresses, lead breaks in the inner leads and poor bonding connections, i.e. cases where the connections between inner leads 5 and the semiconductor chip 2 become loose, are substantially less likely to occur with the invention.

The semiconductor device of Figs. 1 and 2 corresponds to the prior art device of Figs. 6 and 7 or, after sealing, Fig. 8, insofar as the active surface of the semiconductor chip faces upward. The advantages resulting from the increased width of the gap surrounding the semiconductor chip 2 within the device hole 3 and the increased length of the inner leads 5 are achieved in the same way if, corresponding to Fig. 9, the semiconductor chip 2 is arranged to have its active surface facing downward or if corresponding to Fig. 10 only the active surface of the semiconductor chip 2 is sealed with the sealing resin 8.

In the case where the sealing resin 8 is applied only to the active surface of the semiconductor chip 2 (corresponding to Fig. 10), additional stress is imparted during cutting of the outer form of the semiconductor device because the inner leads are exposed externally after sealing. Even in this case, however, the increased gap width and the increased length of the inner leads make the inner leads yielding to external stress occurring at handling and transport after bonding and sealing so that this stress is absorbed and can be relaxed.

Fig. 3 is plan view of another embodiment of the present invention before sealing. This embodiment has the same construction as the embodiment of Figs. 1 and 2 except that the inner leads 5 are differently shaped. In this case, elbow bends 5a are provided substantially midway on the inner leads 5. Consequently, the length of the inner leads 5 is substantially elongated, so that the inner leads 5 become more pliant to the extent that their length is elongated and at the same time become yielding at the bends 5a. Because of this, the inner leads 5 are yieldingly bent at their bends 5a in response to stress occurring for instance because of distortions in the film carrier 1 at transport and handling or other reasons mentioned above. Such stress being absorbed by the bent inner leads 5, breaks in the inner leads 5 that have occurred with the prior art and poor bonding connections are substantially less likely to occur. This advantage is achieved independent of whether the active surface of the semiconductor chip faces upward (corresponding to Fig. 8) or downward (corresponding to Fig. 9) or whether only the active surface of the semiconductor chip is sealed with sealing resin (corresponding to Fig. 10) or the semiconductor chip and part of the surrounding film carrier is sealed (corresponding to Figs. 8 and 9).

Fig. 4 is partial plan view and Fig. 5 a partial sectional view of still another embodiment of the invention before sealing. This embodiment differs from the first embodiment only in the shape of the edge surrounding the device hole 3. Cut-out portions 9 of an elongated rectangular shape (long and narrow) are provided in the edge 3a on both sides of each lead of the conductive pattern 4. Thus, tongue-shaped portions 1b of the film carrier 1 are formed between each two adjacent cut-out portions 9. The respective lead of the conductive pattern 4 on each tongue-shaped portion 1b yields gradually in the direction of the inner leads 5 so that there is no concentration of forces on certain parts of the inner leads 5. Thus, the inner leads 5 together with the tongue-shaped portions 1b of the film carrier 1 yield in response to external forces which may occur due to the reasons mentioned before. Due to this yielding, external forces are absorbed and lead breaks in the inner leads 5 as well as poor bonding connections are substantially prevented from occurring.

Again, the advantages of this embodiment of the invention is achieved independent of whether the semiconductor chip 2 is arranged to have its active surface facing upward or downward and independent of whether only the active surface is sealed or the active surface and a surrounding portion of the film carrier.

Although the explanation was made above on the basis of a so-called 3-layer film carrier as an example, it will be appreciated that the invention is applicable as well to a so-called 2-layer film carrier having the conductive pattern directly laminated to the film carrier. Further, a combination of two or three of the above explained embodiments is also possible to achieve even better results in certain cases.

## Claims

1. A semiconductor device comprising a semiconductor chip (2) inside a device hole (3) of a film carrier (1) having a conductive pattern (4) formed thereon, wherein inner leads (5) projecting from leads of the conductive pattern (4) into the device hole (3) are respectively connected to terminals provided on the semiconductor chip (2), and the semiconductor chip (2) or the semiconductor chip and portions of the conductive pattern (4) are sealed with a sealing resin (8),
   characterized in that the width of a gap formed between the edge of the device hole (3) and the outer periphery of the semiconductor chip (2) is 0.4 mm to 0.8 mm.

2. The semiconductor device according to claim 1, wherein bent portions (5a) are provided substantially at a midway position on said inner leads (5).

3. The semiconductor device according to claim 1 or 2, wherein cut-out portions (9) are provided beside each lead of the conductive pattern (4) in the edge (3a) of the film carrier (1) surrounding the device hole (3).

4. The semiconductor device according to the precharacterizing portion of claim 1, characterized in that bend portions (5a) are provided substantially at a midway position on said inner leads (5).

5. The semiconductor device according to the precharacterizing portion of claim 1, characterized in that cut-out portions (9) are provided beside each lead of the conductive pattern (4) in the edge (3a) of the film carrier (1) surrounding the device hole (3).

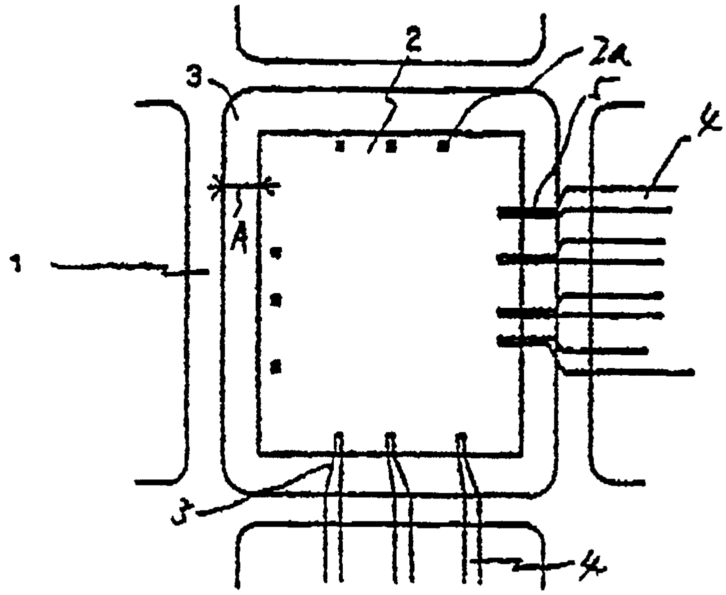


FIG. 1

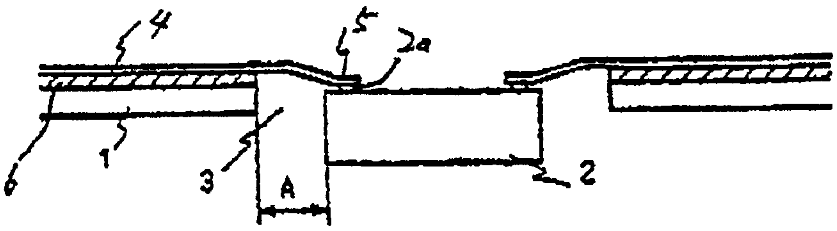


FIG. 2

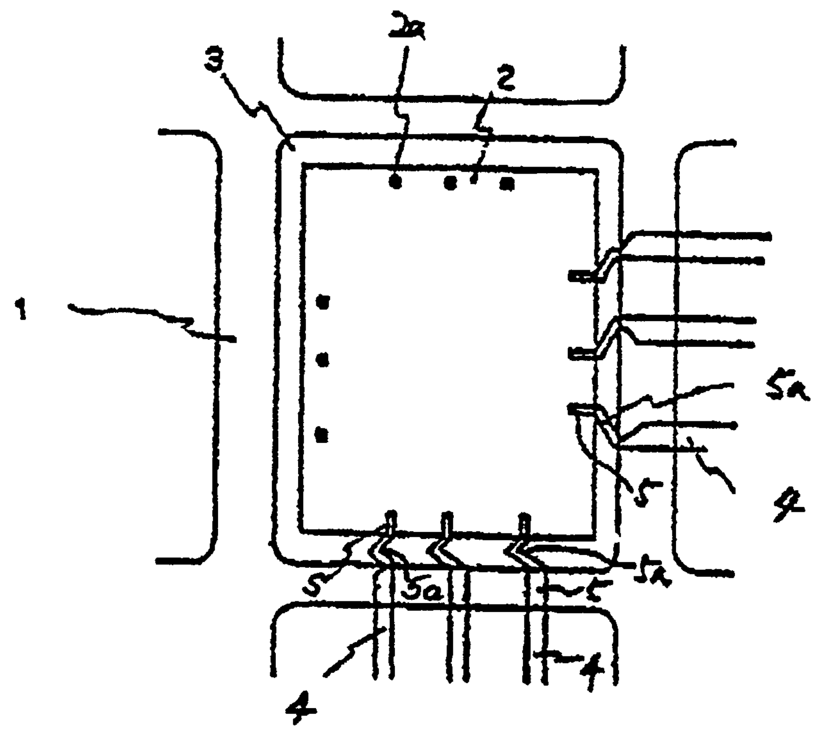


FIG. 3

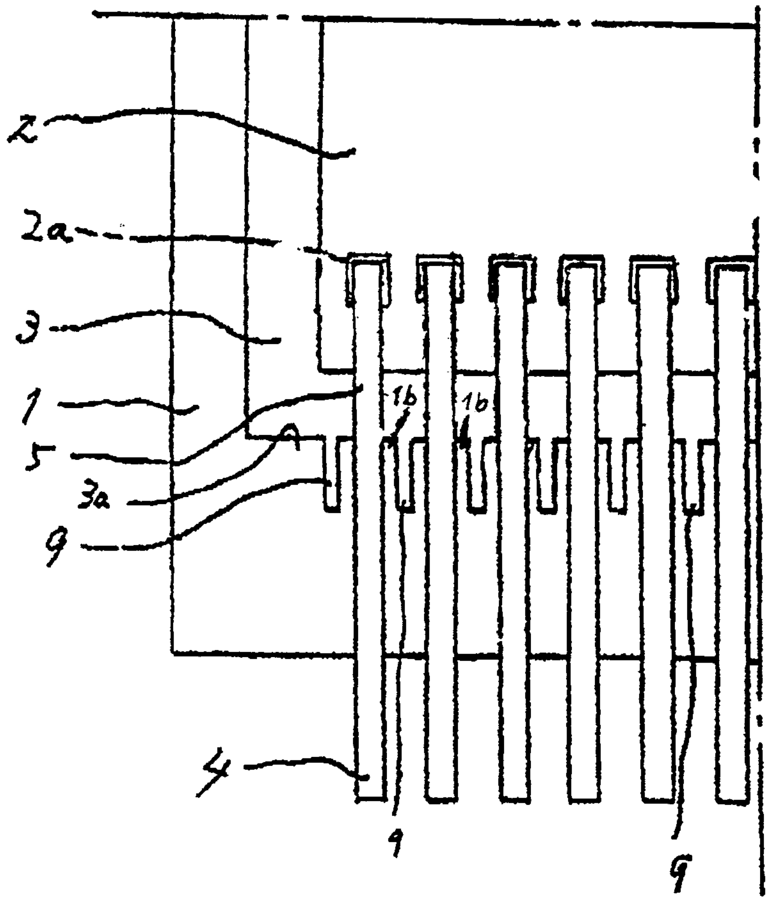


FIG. 4

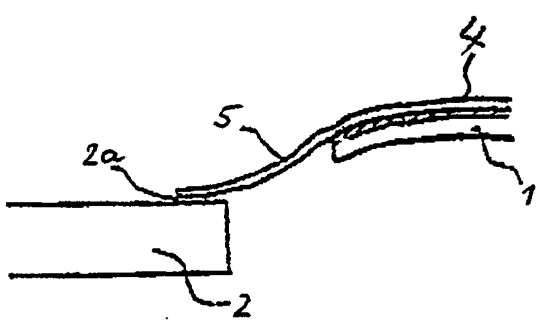


FIG. 5

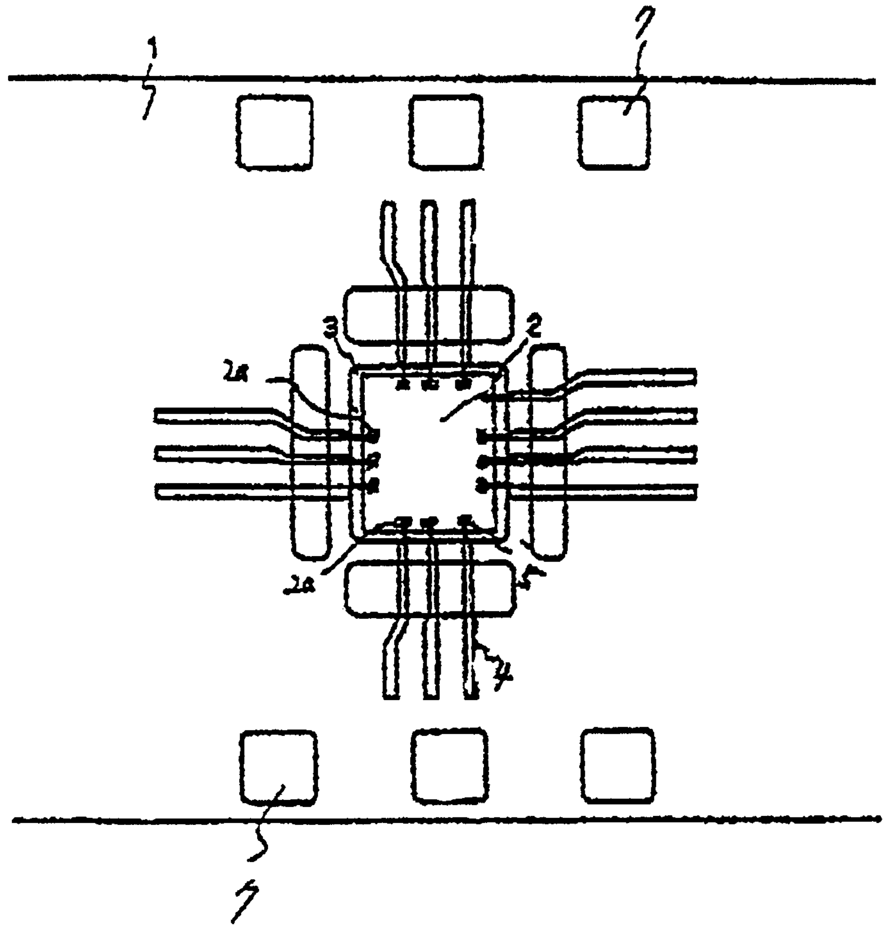


FIG. 6

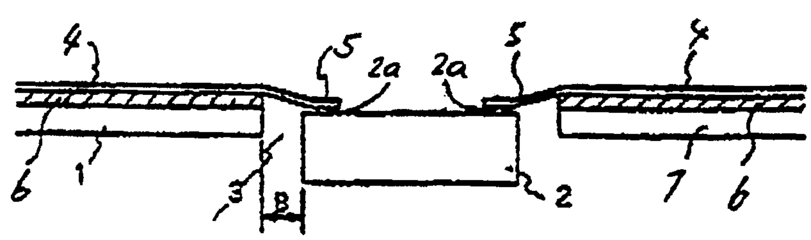


FIG. 7

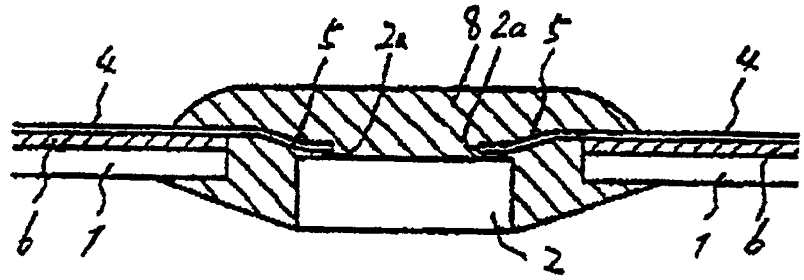


FIG. 8

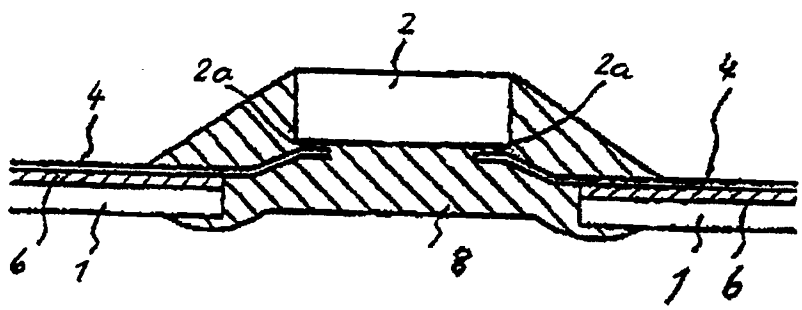


FIG. 9

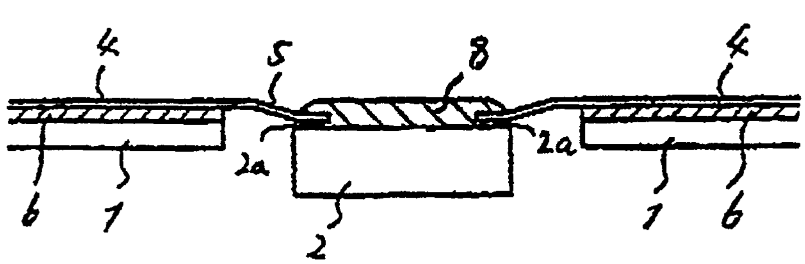


FIG. 10

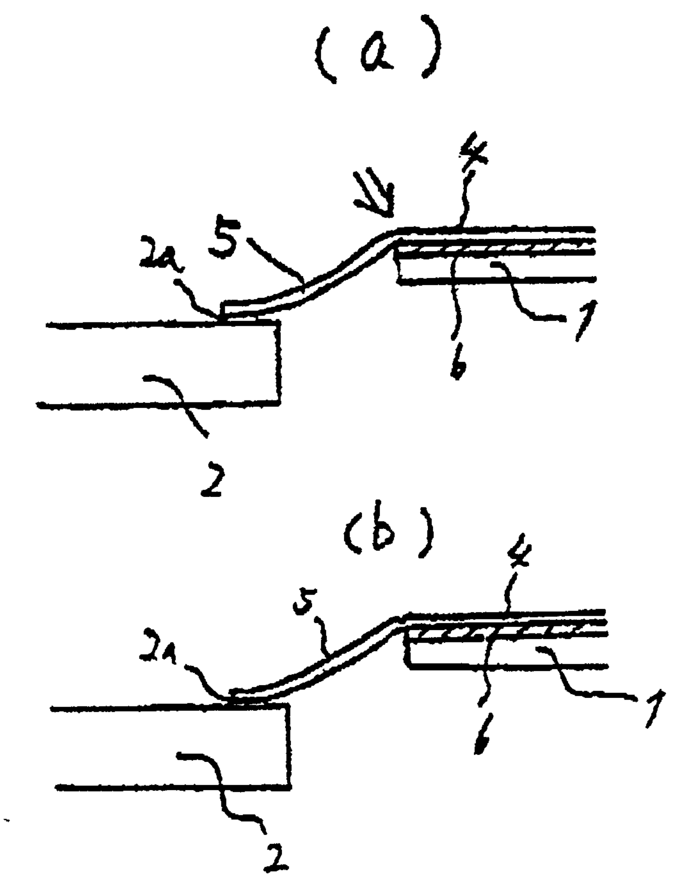


FIG. 11